# DEMANDE DE BREVET EUROPEEN

(11) **EP 4 426 091 A1**
(43) Date de publication de la demande: **04.09.2024**
(21) Numéro de dépôt: 24159751.7
(22) Date de dépôt: 26.02.2024
(51) Int. Cl.: H10N 60/355, H10N 60/85

(54) **DISPOSITIF LIMITEUR DE COURANT SUPRACONDUCTEUR ET AERONEF COMPRENANT UN TEL DISPOSITIF**

(30) Priorité: 28.02.2023 FR 2301840
(71) Demandeur: Airbus SAS, 31700 Blagnac Cedex (FR)
(72) Inventeur: COLLE, M. Alexandre, 31700 BLAGNAC (FR); ABDOUH, M. Reda, 31700 BLAGNAC (FR)
(74) Mandataire: Cabinet Le Guen Maillet

(57) **Abrégé**

L'invention concerne un dispositif limiteur de courant supraconducteur (10) comprenant une enceinte étanche (12) présentant deux ouvertures (12a, 12b) agencées pour permettre une circulation d'un fluide cryogénique (13), le dispositif comprenant en outre une barre de bus supraconductrice (140) et étant agencé tel que :
- une inductance (16) comprenant deux pôles (16a, 16b) est agencée à l'intérieur de ladite enceinte étanche (12) et est disposée en regard d'une partie centrale (14) de ladite barre de bus supraconductrice (140) et,
- chacun des deux pôles (16a, 16b) de ladite inductance (16) est électriquement connecté à une partie terminale (14a, 14b) de ladite barre de bus supraconductrice (140) via un lien de connexion à l'un desdits pôles (16a, 16b).

Avantageusement, le dispositif opère comme un conducteur de courant cryogénique efficace en l'absence de défaut, et comme un limiteur de courant supraconducteur en présence d'un défaut.

## Description

### DOMAINE TECHNIQUE

La présente invention concerne un dispositif limiteur de courant destiné à opérer une limitation de courant en présence d'un défaut dans un circuit électrique. L'invention concerne plus particulièrement un dispositif limiteur de courant supraconducteur. Au moins un mode de réalisation concerne un tel dispositif configuré pour une utilisation à bord d'un aéronef.

### ÉTAT DE LA TECHNIQUE ANTÉRIEURE

De nombreux dispositifs de limitation d'un courant électrique existent et leurs structures varient selon le contexte d'utilisation. Deux architectures de dispositifs limiteurs sont fréquemment utilisées. L'une s'appuie sur une structure résistive, de sorte que la résistance d'un matériau utilisé augmente avec un courant croissant en présence d'un défaut, ce qui produit un effet contraire de limitation du courant dans le matériau. L'autre, ressemblant à un transformateur, s'appuie sur une structure inductive dans laquelle, en présence d'un défaut, le flux magnétique de la bobine secondaire court-circuitée ne s'oppose plus au flux magnétique de la bobine primaire connectée à la ligne d'alimentation et cette dernière voit son impédance croître, ce qui limite alors le courant. De nombreuses applications dans lesquelles circulent de forts courants électriques utilisent des barres de bus (encore appelées parfois *busbar,* de l'anglais) agissant comme des conducteurs guides de courant électrique. Ces barres de bus sont généralement réalisées en cuivre ou en aluminium. Des barres de bus refroidies par un fluide cryogénique sont utilisées dans des systèmes cryogéniques configurés pour réduire sensiblement les pertes par effet Joule, optimiser le rendement de systèmes électriques, et accroître le rapport entre le poids des équipements utilisés et la puissance électrique disponible dans et pour des équipements. Dans le cas d'une barre de bus supraconductrice refroidie par un fluide cryogénique, une limitation d'un courant de défaut peut être introduite et la situation peut être améliorée.

### EXPOSÉ DE L'INVENTION

Un objet de la présente invention est de proposer un dispositif limiteur de courant supraconducteur permettant à la fois de fournir des courants forts en l'absence de défaut et de limiter efficacement un courant de défaut en présence d'un défaut dans un circuit électrique de puissance refroidi par un fluide cryogénique.

A cet effet, il est proposé un dispositif limiteur de courant supraconducteur comprenant une enceinte étanche présentant deux ouvertures agencées pour permettre une circulation d'un fluide cryogénique à l'intérieur de la dite enceinte étanche. Le dispositif limiteur de courant supraconducteur comprend en outre une barre de bus supraconductrice traversant l'enceinte étanche via deux ouvertures de connexion, dont une partie dite « centrale » est agencée à l'intérieur de l'enceinte étanche et dont deux parties dites « terminales » sont respectivement agencées de part et d'autre de la partie centrale et dans la continuité de la partie centrale et sont au moins partiellement agencées à l'extérieur de l'enceinte étanche, le dispositif limiteur de courant supraconducteur étant configuré tel que :
- une inductance comprenant deux pôles est agencée à l'intérieur de l'enceinte étanche et est disposée en regard de la partie centrale de la barre de bus supraconductrice et,
- chacun des deux pôles de l'inductance est électriquement connecté à l'une des parties terminales de la barre de bus supraconductrice via un lien de connexion.

Avantageusement, le dispositif limiteur de courant supraconducteur opère comme un conducteur cryogénique de courant efficace en l'absence de défaut, et comme un limiteur efficace de courant en présence d'un défaut, par l'effet combiné de l'inductance et de la résistance propre de la barre de bus supraconductrice.

Le dispositif limiteur de courant supraconducteur selon l'invention peut comprendre en outre les caractéristiques suivantes, considérées seules ou en combinaison :
- La barre de bus supraconductrice comprend des rubans supraconducteurs dépourvus de couche stabilisatrice.
- La barre de bus supraconductrice comprend un matériau supraconducteur céramique.
- L'inductance comprend un dispositif de détection d'un courant de défaut.

Un autre objet de l'invention est un aéronef comprenant au moins un dispositif limiteur de courant supraconducteur tel que précédemment décrit.

### BRÈVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints :
[Fig. 1] illustre schématiquement un dispositif limiteur de courant supraconducteur selon un mode de réalisation. ;
[Fig. 2] illustre schématiquement et symboliquement le dispositif limiteur de courant supraconducteur déjà représenté sur la Fig. 1 ; et,
[Fig. 3] décrit un aéronef comprenant un dispositif limiteur de courant tel que déjà illustré sur la Fig. 1 et sur la Fig.2.

### EXPOSÉ DÉTAILLÉ DE MODES DE RÉALISATION

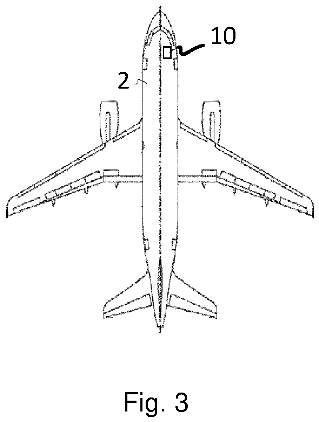

En relation avec la Fig. 3, un aéronef 2 comprend au moins un moteur électrique alimenté grâce à un système cryogénique de production et de fourniture d'énergie électrique à un moteur électrique. Le système cryogénique de production et de fourniture d'énergie électrique au moteur comprend au moins un dispositif limiteur de courant supraconducteur 10.

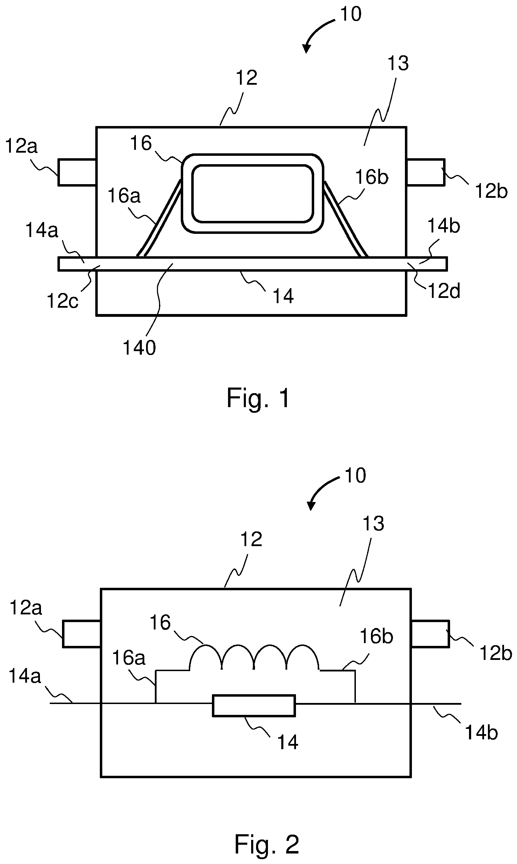

En référence avec la Fig. 1, le dispositif limiteur de courant supraconducteur 10 est un dispositif cryogénique en ce sens qu'il utilise un fluide cryogénique pour réduire la résistivité d'au moins un matériau utilisé pour conduire l'électricité en l'absence de défaut. La résistivité étant réduite du fait des températures cryogéniques, les pertes par effet Joule sont très faibles pour des matériaux conducteurs tels que le cuivre, et sont nulles, en courant continu, pour les matériaux supraconducteurs. Le dispositif limiteur de courant supraconducteur 10 comprend une enceinte étanche 12 dans laquelle circule un fluide cryogénique 13. La circulation du fluide cryogénique 13 est réalisée entre deux ouvertures 12a et 12b de l'enceinte étanche 12. Par exemple, le fluide cryogénique 13 est introduit dans l'enceinte étanche 12 par l'ouverture 12a utilisée comme une ouverture d'entrée et le fluide cryogénique 13 est ensuite extrait de l'enceinte étanche 12 par l'ouverture 12b utilisée comme une ouverture de sortie. La circulation du fluide cryogénique 13 à travers l'enceinte étanche 12 peut être réalisée grâce à une pompe extérieure, non représentée sur la Fig. 1. Avantageusement, et aux fins de réduire les pertes par effet Joule, une barre de bus supraconductrice 140 comprenant une partie centrale 14 et des parties terminales 14a et 14b traverse l'enceinte étanche 12 de sorte que sa partie centrale 14 soit entourée du fluide cryogénique 13 en circulation dans l'enceinte étanche 12. Ainsi, la résistivité de la barre de bus supraconductrice 140 en est réduite, et par voie de conséquence, sa résistance l'est aussi, du fait d'un phénomène de supraconductivité, ce qui entraîne une diminution importante des pertes par effet Joules. Les parties terminales 14a et 14b sont utilisées pour la connexion électrique de la barre de bus supraconductrice 140 et disposent de moyens de refroidissement extérieurs à l'enceinte étanche 12. Ces moyens de refroidissement ne sont pas décrits ici car n'étant pas utiles à la compréhension de l'invention objet de la présente. Selon un mode de réalisation, l'ensemble des circuits de production et de transport de l'énergie électrique utilisés dans le système qui comprend le limiteur de courant supraconducteur 10 utilisent les propriétés des températures cryogéniques pour optimiser le rendement et le rapport entre poids et puissance des équipements en opération.

Des ouvertures 12c et 12d permettent avantageusement une traversée de l'enceinte étanche 12 par les parties terminales 14a et 14b de la barre de bus supraconductrice 140. La barre de bus supraconductrice 140 constituée des parties terminales 14a, 14b agencées de part et d'autre de la partie centrale 14, ainsi que de cette dernière, opère des fonctions de « conducteur de courant » ou encore de « guide de courant ».

Selon un mode de réalisation, la barre de bus supraconductrice 140 comprend des rubans supraconducteurs dépourvus de couche stabilisatrice afin de diminuer le volume et la masse du dispositif qui devient alors plus résistif et donc plus efficace en cas de défaut.

Selon un mode de réalisation encore, la barre de bus supraconductrice 140 est réalisée dans un matériau céramique supraconducteur, ou comprend un tel matériau, de sorte à diminuer le volume et la masse du dispositif qui devient alors plus résistif et donc plus efficace en cas de défaut.

Dans un mode de réalisation, les parties terminales 14a et 14b sont réalisées avec des matériaux conducteurs, par exemple de type cuivre, différents de ceux de la partie centrale 14. Astucieusement, une inductance 16 implémentée sous la forme d'un enroulement (encore appelée usuellement bobine) est connectée aux (entre les) parties terminales de la barre de bus supraconductrice 140 faite des éléments 14a, 14 et 14b. L'inductance 16 présente deux pôles 16a et 16b respectivement reliés aux parties terminales 14a et 14b de la barre de bus supraconductrice 140. Ainsi, en présence d'un courant d'une intensité supérieure ou égale à une valeur seuil prédéterminée et défini comme un courant de défaut, la barre de bus supraconductrice 140 s'échauffe au-delà de ce qui est prévu dans des conditions normales d'utilisation et sa résistivité croît, faisant croître en conséquence sa résistance et son impédance, de sorte que, l'impédance de l'inductance 16 devienne inférieure à l'impédance de la partie centrale 14 de la barre de bus supraconductrice 140. Ces variations ont pour conséquence qu'une partie croissante du courant électrique traversant le dispositif limiteur de courant supraconducteur 10 transite alors par l'inductance 16. Lorsqu'un courant croissant transite via l'inductance 16, un champ magnétique croissant augmente la résistivité de la partie centrale de la barre de bus supraconductrice 140, et donc augmente son impédance, ce qui accroît encore le phénomène de dérivation du courant traversant le dispositif limiteur de courant supraconducteur 10 via l'inductance 16, qui croît elle aussi. Ainsi, la limitation du courant de défaut est majoritairement opérée par l'inductance 16 plutôt que par la résistance propre à la barre de bus supraconductrice 140.

Astucieusement encore, un dispositif de détection de courant de défaut est couplé à l'inductance 16 ou est compris dans l'inductance 16. Le dispositif de détection de courant de défaut est configuré pour mesurer la composante de courant qui traverse l'inductance 16 et pour fournir une information représentative de cette composante à un équipement distant de supervision. L'équipement distant de supervision peut alors activer un système de sécurité adapté pour activer un ou plusieurs circuits de sécurité utiles à la préservation des systèmes et circuits électriques directement ou indirectement concernés par le défaut électrique en présence.

Une autre illustration du dispositif limiteur de courant supraconducteur 10 apparaît sur la Fig. 2 reprenant des symboles usuels de schématisation électrique, électrotechnique ou électronique. Sur cette Fig. 2 la partie centrale de la barre de bus supraconductrice 140 apparait comme une composante résistive de l'impédance globale du dispositif limiteur de courant supraconducteur 10 et l'inductance 16 apparait comme une composante inductive de cette impédance globale. Astucieusement, et du fait du caractère cryogénique et supraconducteur du dispositif limiteur de courant supraconducteur 10, la variation de la partie inductive de l'impédance globale agit positivement sur la variation de la partie résistive de l'impédance globale, ce qui participe à une limitation rapide et efficace du courant de défaut lorsqu'un défaut apparait en aval du dispositif limiteur de courant supraconducteur 10 dans le circuit électrique qui contient le dispositif limiteur de courant supraconducteur 10.

Selon un exemple de réalisation, pour un moteur électrique présentant un courant nominal de 1400 A, une force contre-électromotrice de 300 V et une inductance de phase de 10 µH, alimenté via le dispositif limiteur de courant supraconducteur 10, la fréquence de rotation est de 5000 tours / minute pour une fréquence électrique de 500 Hz. Dans ces conditions, en cas de court-circuit, le courant de défaut s'établirait à une valeur approximative de 10000 A. Aussi, pour limiter le courant de défaut à une valeur pas trop éloignée du courant nominal, et en utilisant un dispositif limiteur de courant supraconducteur tel que décrit, une inductance de 50 µH est nécessaire dans ce dispositif limiteur de courant supraconducteur. Dans le cas d'une barre de bus supraconductrice 140 de quelques mètres de longueur, comprenant un matériau supraconducteur sans couche stabilisatrice, la résistance de la barre de bus supraconductrice 140 peut attendre plusieurs ohms (ici 2,5 ohms, selon l'exemple décrit). Ainsi, la composante résistive de l'impédance globale du dispositif limiteur de courant supraconducteur devient environ 17 fois plus grande que la composante inductive de l'impédance globale et les pertes par effet Joule sont diminuées en présence d'un défaut électrique de type court-circuit.

## Revendications

1. Dispositif limiteur de courant supraconducteur (10) comprenant une enceinte étanche (12) présentant deux ouvertures (12a, 12b) agencées pour permettre une circulation d'un fluide cryogénique (13) à l'intérieur de la dite enceinte étanche (12), le dispositif limiteur de courant supraconducteur (10) comprenant en outre une barre de bus supraconductrice (140) traversant ladite enceinte étanche via deux ouvertures de connexion (12c, 12d), dont une partie dite « centrale » (14), agencée à l'intérieur de ladite enceinte étanche (12) de sorte que sa partie centrale soit entourée du fluide cryogénique (13) en circulation dans l'enceinte étanche (12), traverse ladite enceinte étanche (12) et dont deux parties dites « terminales » (14a, 14b), avec une première et une seconde parties terminales, sont respectivement agencées de part et d'autre de ladite partie centrale (14) et dans la continuité de ladite partie centrale et sont au moins partiellement agencées à l'extérieur de ladite enceinte étanche (10), le dispositif limiteur de courant supraconducteur (10) étant **caractérisé en ce que** :
- une inductance (16) comprenant un premier pôle et un second pôle, est agencée à l'intérieur de l'enceinte étanche (12) et est disposée en regard de la partie centrale (14) de la barre de bus supraconductrice (140) et,
- le premier pôle de l'inductance (16) est électriquement connecté à une première partie terminale (14a) de la barre de bus supraconductrice (140) via un premier lien de connexion (16a), et le second pôle de l'inductance (16) est électriquement connecté à une second partie terminale (14a) de la barre de bus supraconductrice (140) via un second lien de connexion (16b).

2. Dispositif limiteur de courant supraconducteur (10) selon la revendication 1, dans lequel ladite barre de bus supraconductrice (140) comprend des rubans supraconducteurs dépourvus de couche stabilisatrice.

3. Dispositif limiteur de courant supraconducteur (10) selon l'une des revendications 1 et 2, dans lequel ladite barre de bus supraconductrice (140) comprend un matériau supraconducteur céramique.

4. Dispositif limiteur de courant supraconducteur (10) selon l'une des revendications 1 à 3, dans lequel l'inductance (16) comprend un dispositif de détection d'un courant de défaut.

5. Aéronef (2) comprenant au moins un dispositif limiteur de courant supraconducteur (10) selon l'une des revendications 1 à 4.
